# EUROPEAN PATENT APPLICATION

(11) **EP 4 009 741 A1**
(43) Date of publication of application: **08.06.2022**
(21) Application number: 20211464.1
(22) Date of filing: 03.12.2020
(51) Int. Cl.: H05B 3/42, F24H 9/20

(54) **HEATING SYSTEM COMPONENT FOR SENSING A FIRST AND SECOND TEMPERATURE**

(71) Applicant: Bleckmann GmbH & Co. KG, 5112 Lamprechtshausen (AT)
(72) Inventor: HÖFER, Johann, 5113 St. Georgen (AT); STEGER, Bernhard, 5661 Rauris (AT)
(74) Representative: Eisenführ Speiser

(57) **Abstract**

The present invention relates to A heating system component (18), comprising a carrier unit (26) having a dry side (38), a wet side (40), a groove (34) provided on the dry side (38), and a medium leading section (42) at least partially opposite a medium flow area on the wet side (40); a heating unit (28) at least partially received in the groove (34); a heat conducting plate assembly (46) that comprises a first heat capturing plate portion (54) that is thermally coupled to the heating unit (28), a second heat capturing plate portion (56) that is thermally coupled to the medium leading section (42) of the carrier unit (26), a first heat releasing plate portion (58), and a second heat releasing plate portion (60); at least one printed circuit board (48) comprising circuitry (70) with a first sensor area (72) and a second sensor area (74), wherein the circuitry (70) is configured to sense a first temperature at the first sensor area (72) and a second temperature at the second sensor area (74); a housing (50) accommodating at least a part of the printed circuit board (48) and at least a part of the heat conducting plate assembly (46) in such a way that the first sensor area (72) is thermally coupled to the first heat releasing plate portion (58) and the second sensor area (74) is thermally coupled to the second heat releasing plate portion (60).

## Description

### FIELD OF THE INVENTION

The invention relates to a heating system component, to a heated conveyer pump, to a method for manufacturing a heating system component, to a printed circuit board, and to a housing.

### BACKGROUND OF THE INVENTION

In many types of domestic appliances or domestic machines, it is necessary to heat up a fluid medium, such as for example water. For the purpose of heating up the medium, commonly a heating system component with a heating unit is provided, wherein the medium is thermally coupled to the heating unit.

In order to monitor a temperature of the medium and/or to determine a possible overheating of the heating unit, such heating system components are usually provided with temperature sensors that sense the temperature of the medium and/or the heating unit. These temperature sensors are usually bulky and therefore provide little flexibility in positioning and coupling the temperature sensors with the medium and/or the heating unit.

If, in addition, both the temperature of the medium to be heated and the temperature of the heating unit are monitored, this intensifies the problem.

An object of the present invention is therefore to provide a heating system component, a heated conveyer pump, and a method for manufacturing a heating system component, a printed circuit board, and a housing, which address the aforementioned problems.

### SUMMARY OF THE INVENTION

According to a first aspect of the present invention as defined in claim 1, there is provided a heating system component, comprising a carrier unit having a dry side, a wet side, a groove provided on the dry side, and a medium leading section at least partially opposite the medium flow area on the wet side; a heating unit at least partially received in the groove; a heat conducting plate assembly that comprises a first heat capturing plate portion that is thermally coupled to the heating unit, a second heat capturing plate portion that is thermally coupled to the medium leading section of the carrier unit, a first heat releasing plate portion, and a second heat releasing plate portion; at least one printed circuit board comprising circuitry with a first sensor area and a second sensor area, wherein the circuitry is configured to sense a first temperature at the first sensor area and a second temperature at the second sensor area; a housing accommodating at least a part of the printed circuit board and at least a part of the heat conducting plate assembly in such a way that the first sensor area is thermally coupled to the first heat releasing plate portion and the second sensor area is thermally coupled to the second heat releasing plate portion. In a preferred embodiment, the first heat capturing plate portion is coupled to the first heat releasing portion and the second heat capturing plate portion is coupled to the second heat releasing portion.

The heat conducting plate assembly and the printed circuit board as defined above are adapted to allow measurements of two different temperatures at two different surfaces. The housing is adapted to accommodate at least partially the heat conducting plate assembly and the printed circuit board, combining two temperature measurements in a single housing. Additionally, the printed circuit board provides a circuitry in the immediate vicinity, allowing direct access for plugs or further processing units. The heating system component defined above therefore is more compact and increases the flexibility regarding the location of installation.

In a preferred embodiment, the second heat capturing plate portion is exclusively thermally coupled to the medium leading section on the dry side of the carrier unit.

As a result of the exclusive thermal coupling, the second heat capturing plate portion primarily captures or acquires heat so that the temperature of the medium can be adapted or controlled.

In another preferred embodiment, the heat conducting plate assembly has a shape and/or is made of a material, in particular a composite material, such that a thermal conductivity from the first heat capturing plate portion to the first heat releasing plate portion is larger than to the second heat releasing plate portion and a thermal conductivity from the second heat capturing plate portion to the second heat releasing plate portion is larger than to the first heat releasing plate portion. The heat conducting plate assembly may comprise a single plate body. Alternatively, the heat conducting plate assembly may comprise a plurality of plate bodies such as two, three, four or more plate bodies that are spatially separated. The plate bodies can initially be connected in one piece and separated from each other after they are mounted on the carrier unit. The separation can be done by a mechanical process, for example, cutting, sawing, plier cutting, and oxy-fuel cutting.

Alternatively or in addition, the heat conducting plate assembly can be attached to the carrier unit or the heating unit in such a way that the first heat capturing plate portion is directly connected to the outside of the heating unit and the second heat capturing plate portion is not connected to the heating unit, but only to the medium leading section.

Such a heat conducting plate assembly allows the first heat releasing plate portion to primarily receive heat from the first heat capturing plate portion and allows the second heat releasing plate portion to primarily receive heat from the second heat capturing plate portion, which increases an accuracy of temperature measurements.

In a further preferred embodiment, the heat conducting plate assembly comprises a recess that extends at least partially between the first heat releasing plate portion and the first heat capturing plate portion on one side and the second heat releasing plate portion on the other side. The recess may fully extend between the first heat releasing plate portion and the first heat capturing plate portion on one side and the second heat releasing plate portion on the other side. Additionally or alternatively, a tapering or thermally insulating material may be provided at the extension of the recess. The recess may separate the heat conducting plate assembly into a first plate body and a second plate body that is spatially separate from the first plate body.

The recess (or the tapering and thermally insulating material) provides at least partly a thermal insulation between the first heat releasing plate portion and the first heat capturing plate portion on one side and the second heat releasing plate portion on the other side. Consequently, a heat transfer from the first heat capturing plate portion to the second heat releasing plate portion is reduced.

In a preferred embodiment, the heat conducting plate assembly comprises a first bent between the first heat capturing plate portion and the first heat releasing plate portion and a second bent between the second heat capturing plate portion and the second heat releasing plate portion. The first and second bent may have an angle between 25° and 155°, preferably between 45° and 135°, and further preferably between 80° and 100°, such as at least essentially 90°. The first and second bents may be arranged such that the first and second heat releasing plate portions are arranged in a common plane.

The first and second bents cause the first and second heat releasing plate portions to extend away from the carrier unit, allowing easier and space saving access for thermally coupling the heat conducting plate assembly to the printed circuit board.

In another preferred embodiment, the heating system component further comprises at least one biasing element configured to bias the first heat releasing plate portion towards the first sensor area and the second heat releasing plate portion towards the second sensor area. The biasing element can be positioned on the housing in such a way that it presses at least one section of the housing against the first heat releasing plate portion, and vice versa, to establish good contact between the first heat releasing plate portion and the first sensor area.

The biasing element reduces the probability of thermal decoupling of the first and second heat releasing plate portions off the first and second sensor areas.

The biasing element may comprise a metal spring and/or a metal strap. The biasing element may comprise a plurality of metal springs and/or metal straps. Alternatively or additionally, the biasing element may comprise a plastic, wherein the plastic is preferably heat resistant. The biasing element may be attached to a hook of the housing. Alternatively or additionally, the biasing element may frictionally engage the housing.

A spring or strap comprising metal and/or a heat resistant plastic has a comparably high resistance to heat and therefore improves the lifespan of the heating system component.

In a further preferred embodiment, the housing comprises at least one holding element preferably arranged at least partially between a biasing element and the first and/or second heat releasing plate portions. The housing may comprise a holding element for each heat releasing plate portion. The housing and the at least one holding element may be integrally formed. In principle it is also possible that the design of the at least one holding element is sufficient to press one or both sensor areas of the printed circuit board against one or both heat releasing plate portions in such a way that a good contact is achieved between these areas or portions.

The holding element can be frictionally engaged between the biasing element and each corresponding heat releasing plate portion, securing the housing to the heat conducting plate assembly.

According to a preferred embodiment, the printed circuit board comprises at least one of a glass-reinforced epoxy laminate material of the NEMA grade FR-4, a flame retardant composite epoxy material such as CEM III, an insulated metal substrate, a rigid-flex board, and a ceramic printed circuit board. The epoxy in the glass-reinforced epoxy laminate material of the NEMA grade FR-4 and/or the flame retardant composite epoxy material such as CEM III may have a glass-transition temperature Tg larger than 170 °C.

The glass-reinforced epoxy laminate material of the NEMA grade FR-4 and a flame-retardant composite epoxy material such as CEM III are flame retardant and therefore reduce the risk for flame formation caused by the heating unit. The insulated metal substrate and the ceramic printed circuit board can be operated at very high temperatures and have a long lifespan. The rigid-flex board enables a compact arrangement of printed circuit boards inside the housing. A material with a glass-transition temperature Tg larger than 170 °C can operate safely in most water heating applications that do not exceed the boiling temperature of water, such as an operation temperature of 90°.

According to a preferred embodiment, the printed circuit board has a thickness of at least essentially 0.3mm. Alternatively, the printed circuit board has a thickness of at least essentially 0.5mm, 1.0mm or generally smaller than or equal to 1.6mm.

A printed circuit board with a thickness smaller than a standard thickness of 1.6mm (such as 0.3mm) has less weight and therefore a smaller heat capacity and a smaller thermal resistance, which results in less time required to reach thermal equilibrium. Consequently, the temperature measurements are more accurate and faster.

In another preferred embodiment, the housing comprises at least one support plate or element and the printed circuit board is arranged on the support plate forming a plate stack that comprises the support plate and the printed circuit board, wherein the plate stack is dimensioned such that it can be received by a standard edge connector socket, such as a RAST 2.5 connector or a RAST 5 connector. The support plate and the printed circuit board may be arranged flush at a face opposite the first and second heat releasing plate portions. The plate stack may have a thickness of at least essentially 1.6mm.

The support plate mechanically stabilizes the plate stack and provides sufficient thickness in the case that the thickness of the printed circuit board is not sufficient to be engaged by the standard edge connector socket.

In a preferred embodiment, the printed circuit board has two layers and a circuitry is arranged on both layers. The first layer may be arranged on a first surface of the printed circuit board and the second layer may be arranged on a second surface opposite of the first surface of the printed circuit board. The printed circuit board may comprise at least one electrical connection between the first and second layer. The at last one electrical connection may be provided through an opening of the printed circuit board.

Using two layers allows increases a circuitry density of the printed circuit board, which allows for a more compact heating system component.

In a further preferred embodiment, the circuitry comprises a processing unit configured to receive first temperature data indicative of the first temperature sensed by the first sensor area at the heating unit and second temperature data indicative of the second temperature sensed by the second sensor area at the medium leading section, wherein the processing unit is configured to determine the first temperature based on the first temperature data and the second temperature based on the second temperature data. The processing unit allows determining the first and second temperature by the circuitry itself, which improves compatibility with other devices, as the other devises do not require an algorithm for converting the first and second temperature data into the first and second temperature.

According to a further preferred embodiment, the printed circuit board comprises a third sensor area that is thermally coupled to a third heat releasing plate portion of the heat conducting plate assembly and the printed circuit board is configured to sense a third temperature at the third sensor area, wherein the printed circuit board comprises two layers and the first and second sensor areas are arranged on one of the two layers and the third sensor area is arranged on the other one of the two layers.

The third sensor area does not require a second printed circuit board and yet allows determining redundant temperature measurements or determining a mean temperature, which allows for a more accurate temperature measurement while retaining a compact design for the heating system component.

In a preferred embodiment, the circuitry comprises a first, second and third electrode and the first sensor area comprises a first thermistor and the second sensor area comprises a second thermistor, wherein the first thermistor is electrically connected to the first and second electrode and the second thermistor is electrically connected with the second and third electrode.

Such a circuitry has a low complexity and requires a small number of electrodes.

According to a preferred embodiment, the printed circuit board comprises at least one of an opening (such as two or several openings) and a recessed edge. The printed circuit board may comprise a plurality of edges. The recessed edge is preferably arranged between the first and second sensor area. The at least one opening is preferably arranged close to the first and second sensor area. Alternatively, printed circuit board may have a rectangular shape with no openings and/or no recessed edge.

The at least one opening and the recessed edge result in a smaller mass and therefore a smaller thermal capacity of the printed circuit board. The printed circuit board therefore reaches thermal equilibrium faster, which results in a more accurate and/or fast temperature measurement. A smaller distance of the openings and recessed edge relative to the sensor areas result in a locally smaller heat capacity at the sensor area.

In a preferred embodiment, the carrier unit and the heating unit have a coupling surface that is configured to allow thermal coupling to the first and second heat capturing portions, wherein the coupling surface has a rotational symmetry around a symmetry axis and the first and second heat capturing plate portions each have a surface shape that aligns with a shape of the coupling surface.

The heating system component as described herein allows for a compact arrangement of a temperature sensor comprising the heat conducting plate assembly, the housing, and the printed circuit board. The small size of the temperature sensor enables a larger range of possible coupling positions. The coupling surface with the rotational symmetry allows for a large range of selections of coupling positions. Commonly, the heating unit has a temperature gradient (at end portions of the heating unit or due to a varying pitch of a heating coil). The coupling surface can extend along the temperature gradient, which allows coupling the temperature sensor selectively to a coupling position that suits a preferred temperature range of the temperature sensor. The coupling position may be selected during manufacturing or later during maintenance or a modification.

According to a preferred embodiment, the heating system component comprises a foil arranged between the first heat releasing plate portion and the first sensor area as well as between the second heat releasing plate portion and the second sensor area, wherein the foil comprises a material with electrically isolating and thermally conducting properties, such as a polyimide foil (e.g., Kapton MT). The foil may be attached to the first and second heat releasing plate portion, to the printed circuit board or only to the first and second sensor area.

The foil can prevent a possible electrical shortcut at the first and second sensor area caused by the first and second heat releasing plate portions. Furthermore, the foil forms a mechanical protection for the first and second sensor area. Since the foil is thermally conducting, a heat barrier caused by the foil is minimized.

In a further preferred embodiment, the first and second sensor areas are arranged on a surface of the printed circuit board that faces away from the first and second heat releasing plate portions. In such a case, the printed circuit board may be thermally conducting. The printed circuit board may comprise an insulated metal substrate and/or a glass-reinforced epoxy laminate material of the NEMA grade FR-4 that thermally couples the first and second heat releasing plate portions to the first and second sensor areas. Again, an electrically insulating foil may be provided, which can be arranged in the same way as described above.

Such an arrangement of the first and second sensor area prevents mechanical damage to the first and second sensor area caused by the first and second heat releasing plate portions.

According to a second aspect of the present invention, there is provided a heated conveyer pump for conveying a fluid medium, comprising a pump housing accommodating an impeller, a drive unit for driving the impeller; and the heating system component as described herein.

According to a third aspect of the present invention, there is provided a method for manufacturing a heating system component, wherein the heating system component comprises a carrier unit having a dry side, a wet side, a groove provided on the dry side, and a medium leading section at least partially opposite the medium flow area on the wet side, a heating unit, a heat conducting plate that comprises a first heat capturing plate portion, a second heat capturing plate portion, a first heat releasing plate portion, and a second heat releasing plate portion, at least one printed circuit board comprising circuitry with a first sensor area and a second sensor area, wherein the circuitry is configured to sense a first temperature at the first sensor area and a second temperature at the second sensor area, and a housing, the method comprising the steps of arranging the heating unit at least partially in the groove of the carrier unit; providing of the heat conducting plate assembly wherein the first heat capturing plate portion is connected with the second heat capturing plate portion and/or the first heat releasing plate portion is connected with the second heat releasing plate portion; thermally coupling the first heat capturing plate portion to the heating unit and the second heat capturing plate portion to the medium leading section of the carrier unit; separating the connection between the first heat capturing plate portion and the second heat capturing plate portion and/or the first heat releasing plate portion and the second heat releasing plate portion; accommodating at least a part of the printed circuit board and at least a part of the heat conducting plate assembly in the housing in such a way that the first sensor area is thermally coupled to the first heat releasing plate portion and the second sensor area is thermally coupled to the second heat releasing plate portion.

The connection between the first and second heat capturing plate portions and/or between the first and second heat releasing plate portion can, for example, be made by providing the plate portions in one piece and, after mounting the plate assembly on the carrier unit, separating this connection, for example by a mechanical process. It is also possible that the plate portions, in particular the two heat releasing plate portions, are connected to each other by means of a separate connection element, such as a connecting cap, which embraces both portions. This connecting cap can be removed after mounting the plate assembly on the carrier unit.

During the thermal coupling of the first and second heat capturing plate portions, the connecting element maintains a spatial relationship between the first and second plate body that ensures thermal isolation between first and second plate body and ensures an arrangement of the first and second heat releasing plate portions that can be thermally coupled to printed circuit board.

In a preferred embodiment, the heating unit comprises a heating coil and a pitch of the coil varies along an extension of the heating coil, wherein the carrier unit and the heating unit have a coupling surface that extends along at least a part of the varying pitch of the heating coil and that is configured to allow thermal coupling to the first and second heat capturing portions, wherein the method comprises determining a coupling position for the first and second heat capturing plate portions on the coupling surface based on a target coil pitch and/or a target temperature that can be generated by an associated position on the coupling surface; and thermally coupling the first and second heat capturing plate portions at the determined coupling position.

According to a fourth aspect of the present invention, there is provided a printed circuit board comprising circuitry with a first sensor area and a second sensor area, wherein the circuitry is configured to sense a first temperature at the first sensor area and a second temperature at the second sensor area.

According to a preferred embodiment, the printed circuit board comprises at least one of a glass-reinforced epoxy laminate material of the NEMA grade FR-4, a flame-retardant composite epoxy material such as CEM III, an insulated metal substrate, a rigid-flex board, and a ceramic printed circuit board. The epoxy in the glass-reinforced epoxy laminate material of the NEMA grade FR-4 and/or the flame retardant composite epoxy material such as CEM III may have a glass-transition temperature Tg larger than 170 °C. According to a preferred embodiment, the printed circuit board has a thickness of at least essentially 0.3mm. Alternatively, the printed circuit board has a thickness of at least essentially 0.5mm, 1.0mm or generally smaller than or equal to 1.6mm.

In a preferred embodiment, the printed circuit board has two layers and a circuitry is arranged on both layers. The first layer may be arranged on a first surface of the printed circuit board and the second layer may be arranged on a second surface opposite of the first surface of the printed circuit board. The printed circuit board may comprise at least one electrical connection between the first and second layer. The at last one electrical connection may be provided through an opening of the printed circuit board.

According to a preferred embodiment, the printed circuit board comprises at least one of an opening (such as two openings) and a recessed edge. The printed circuit board may comprise a plurality of edges. The recessed edge is preferably arranged between the first and second sensor area. The at least one opening is preferably arranged close to the first and second sensor area.

According to a fifth aspect of the present invention, there is provided a housing configured to accommodate at least a part of a printed circuit board and at least a part of a heat conducting plate assembly in such a way that a first sensor area of the printed circuit board is thermally coupled to a first heat releasing plate portion of the heat conducting plate assembly and a second sensor area of the printed circuit board is thermally coupled to the second heat releasing plate portion of the heat conducting plate assembly.

In a further preferred embodiment, the housing comprises at least one holding element configured to be arranged at least partially between a biasing element and the first and second heat releasing plate portions. The housing may comprise a holding element for each heat releasing plate portion. The housing and the at least one holding element may be integrally formed.

In another preferred embodiment, the housing comprises a support plate and the printed circuit board is arranged on the support plate forming a plate stack that comprises the support plate and the printed circuit board, wherein the plate stack is dimensioned such that it can be received by a standard edge connector socket, such as a RAST 2.5 connector or a RAST 5 connector. The support plate and the printed circuit board may be arranged flush at a face opposite the first and second heat releasing plate portions. The plate stack may have a thickness of at least essentially 1.6mm. The support plate may have a thickness of 1.3mm.

A support plate with a thickness of 1.3mm combined with a printed circuit board that has a thickness of 0.3mm results in a plate stack that has a thickness of 1.6mm. Therefore, such a plate stack is compatible with standard edge connector sockets that are configured to receive a printed circuit board with a standard thickness of 1.6mm.

These and other aspects of the invention will be apparent from and elucidated with reference to the embodiments described hereinafter.

### BRIEF DESCRIPTION OF THE DRAWINGS

In the following drawings:
- Fig. 1A: shows an exploded schematic view of an embodiment of a heated conveyer pump;
- Fig. 1B: shows the heated conveyer pump shown in Fig. 1A in an assembled state;
- Fig. 1C: shows the heated conveyer pump depicted in Fig. 1B with a medium flow in an opposite direction;
- Fig. 2: shows a perspective view of an embodiment of the heating system component;
- Fig. 3: shows the heating system component depicted in Fig. 2 with an exploded view of the temperature sensor;
- Fig. 4A: shows a perspective view of a heat conducting plate assembly with a single plate body;
- Fig. 4B: shows a perspective view of a heat conducting plate assembly with two plate bodies;
- Fig. 5A: shows a partial top view of the heating system component and the heat conducting plate assembly;
- Fig. 5B: shows a partial cross section through the heating system component along a plane A-A as shown in Fig. 5A;
- Fig. 5C: shows a partial cross section through the heating system component along a plane B-B as shown in Fig. 5A;
- Fig. 6: shows a perspective view of a printed circuit board;
- Fig. 7A: shows a perspective view of the housing;
- Fig. 7B: shows a perspective cutaway view of the housing shown in Fig. 7A from essentially an opposite viewing angle;
- Fig. 8A: shows a biasing element;
- Fig. 8B: shows the temperature sensor with the biasing element attached thereto;
- Fig. 8C: shows a perspective view of the temperature sensor with an alternative biasing element in form of a metal strap;
- Fig. 8D: shows a cutaway perspective view of the temperature sensor with an alternative biasing element in form of the metal strap;
- Fig. 9: shows schematically and exemplarily an embodiment of a method for manufacturing a heating system component such as described herein;
- Fig. 10A: shows a perspective view of a heat conducting plate assembly, wherein a connecting element comprises a crosspiece between a first plate body and a second plate body;
- Fig. 10B: shows the heat conducting plate assembly depicted in Fig. 10A, wherein the crosspiece is cut through;
- Fig. 10C: shows a heat conducting plate assembly with a different example for a connecting element that comprises a connecting cap with openings configured to receive the first and second plate body;

- Fig. 10D: shows the heat conducting plate assembly depicted in Fig. 10C, wherein the connecting cap is removed from the first and second plate body;
- Fig. 11A: shows a schematic top view of the heating system component with the heating unit;
- Fig. 11B: shows a schematic top view of the heating system component shown in Fig. 11A with the temperature sensor arranged at different positions on top of a coupling surface;
- Fig. 12A: shows a partial top view of a first embodiment of the heating system component;
- Fig. 12B: shows a partial cross section through the heating system component and the temperature sensor along a plane A-A as shown in Fig. 12A;
- Fig. 13: shows a second embodiment of the heating system component;
- Fig. 14A: shows a partial top view of a third embodiment of the heating system component; and
- Fig. 14B: shows a partial cross section through the heating system component along a plane A-A as depicted in Fig. 14A.

### DETAILED DESCRIPTION OF EMBODIMENTS

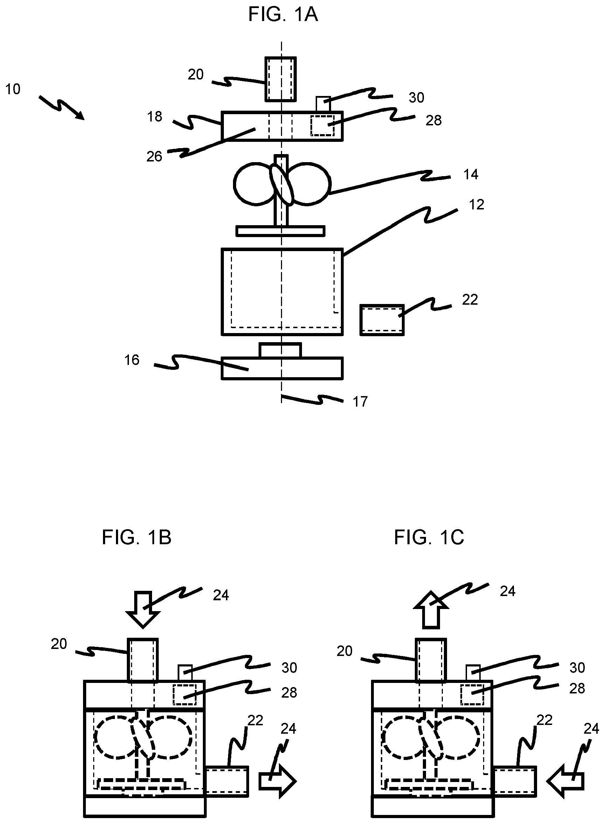

Fig. 1A shows an exploded view of an embodiment of a heated conveyer pump 10. Heated conveyer pump 10 comprises a pump housing 12 accommodating an impeller 14. Heated conveyer pump 10 also comprises a drive unit 16 for driving impeller 14, wherein the drive unit 16 is configured to be attached to the pump housing 12 from the outside such that the drive unit 16, the pump housing 12, and the impeller 14 are arranged coaxially along a common central longitudinal axis 17. Heated conveyer pump 10 further comprises a heating system component 18.

Fig. 1B shows heated conveyer pump 10 shown in Fig. 1A in an assembled state. Heating system component 18 is configured to be attached into an opening of pump housing 12 such that heating system 18 and pump housing 12 define a volume that is adapted to receive a medium. The medium can be a liquid such as water, oil, gasoline, or a cleaning solvent. For example, the medium may be water to be heated for use in a dishwashing machine or washing machine.

Drive unit 16 is configured to drive impeller 14. Impeller 14 shown in Fig. 1B is configured to rotate in a way that generates a pressure in the medium that causes the medium to flow through pump housing 12. To this end, a first pipe 20 is attached into an opening of heated conveyer pump 10. A second pipe 22 is attached to an opening of pump housing 12. Driven by pressure created by impeller 14, a medium 24 is sucked into first pipe 20, conveyed through pump housing 12 and released out of second pipe 20. It should be noted that the direction of the flow of medium 24 is in principle not limited to the direction shown in Fig. 1B. Fig. 1C shows a heated conveyer pump 10 with an opposite medium flow, wherein medium 24 is sucked into second pipe 22 and released out of first pipe 20.

It is further noted that the positions of first and second pipe 20, 22 is not limited to the ones shown in Figs. 1A-C. Alternatively, first and second pipes 20, 22 may both be attached at heating system component 18 or both be attached at pump housing 18.

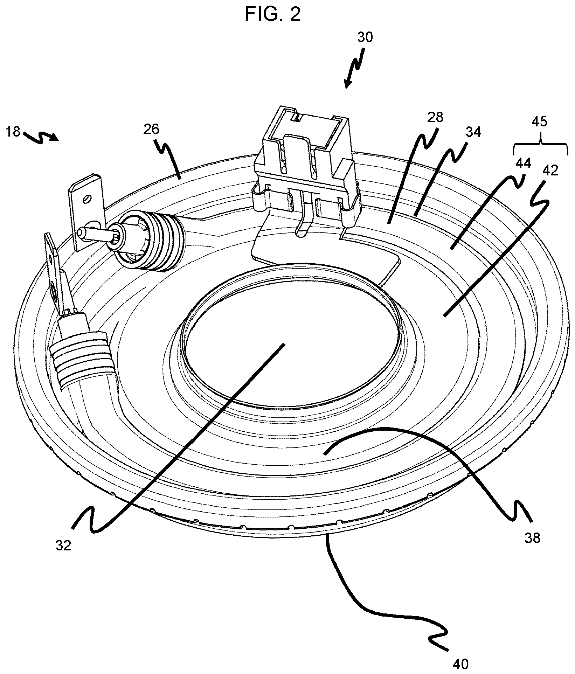

As also shown in Fig. 2, heating system component 18 comprises a carrier unit 26 with a wet side that faces the inside of pump housing 12 (and consequently medium 24) and a dry side opposite the wet side, which does not face medium 24 in pump housing 12.

Heating system component 18 further comprises a heating unit 28 that is thermally coupled to medium 24 inside pump housing 12. Heating unit 28 is configured to generate heat, which is transferred to medium 24 inside pump housing 12. Heated conveyer pump 10 is consequently configured to convey the medium through pump housing 12 due to a pressure generated by impeller 14 and to heat up medium 24 with heat generated by heating unit 28 while medium 24 passes through pump housing 12.

Heating unit 28 generates heat and flowing medium 24 removes heat, wherein different rates of heat generation, medium flow and filling level of pump housing 12 differently influence the temperature medium 24 reaches when released out of heated conveyer pump 10. Heating system component 18 comprises a temperature sensor 30 that allows determining the temperature of medium 24 and heating unit 28. Temperature sensor 30 will be explained in more detail below.

Fig. 2 shows a perspective view of a first embodiment of heating system component 18. Heating system component 18 comprises carrier unit 26 with a carrier opening 32 configured to receive a pipe such as first pipe 20 for passing the medium shown in Figs. 1A-C. Alternatively, carrier unit 26 does not comprise a carrier opening 32 in at least approximately the shape of a circle and pump housing 12 comprises two openings for receiving and releasing medium 24. Carrier unit 26 has a shape that is essentially rotationally symmetric around a symmetry axis (not shown).

The preferably plate-like carrier unit 26, which has at least approximately the shape of a circular disc, comprises a dry side 38 and a wet side 40. Wet side 40 is a side of carrier unit 26 that faces medium 24 to be heated. Dry side 38 is a side of carrier unit 26 opposite of wet side 40, wherein dry side 38 does not face medium 24.

Carrier unit 26, which is made of a material with good thermal conductivity, has a groove 34 that extends around carrier opening 32 and along a circular path that has the same rotational symmetry axis as the shape of carrier unit 26. Heating system component 18 further comprises heating unit 28 received in groove 34 of carrier unit 26. The outer contour of heating unit 28, at least in the area with which it is seated in groove 34, is adapted to the contour of groove 34 in such a way that the outer side of heating unit 28 lies at least approximately completely against groove 34. In the embodiment shown, heating unit 28 has a rectangular or square cross section, so that groove 34 has a corresponding "counter cross section" in the form of a rectangle or square. Heating unit 28 may be attached to groove 26 frictionally engaged or with an attachment material like a soldering paste or glue. Heating unit 28 has the shape of an open loop with two heating unit electrodes that are configured to be connected to a power source. Heating unit 28 comprises a heating element (not shown) in form of a coil that converts electrical energy into heat. However, heating unit 28 may comprise different forms of heating elements. Groove 34 is thermally coupled to wet side 40 of carrier unit 26 (by virtue of a thin wall thickness of carrier unit 26 at groove 34). Therefore, heating unit 28 is configured to transfer heat generated by heating unit 28 via groove 34 to medium 24 flowing along wet side 40.

Heating system component 18 comprises a temperature sensor 30 that allows sensing a temperature of heating unit 28 and a temperature of medium 24 flowing along wet side 40. Carrier unit 26 comprises on dry side 38 a medium leading section 42 at a surface of dry side 38 that is thermally coupled to wet side 40. Medium leading section 42 is provided between carrier opening 32 and groove 34, which receives heater unit 28, and extends concentrically to carrier opening 32. Therefore, assuming equilibrium conditions, medium leading section 42 adapts the same temperature (or essentially the same temperature) as medium 24 flowing along wet side 40. Furthermore, heating unit 28 has a heating unit coupling surface 44 that faces away from wet side 40 and that adapts the same temperature (or essentially the same temperature) as heating unit 28. Temperature sensor 30 is thermally coupled to medium leading section 42 and heating unit coupling surface 44 as will be described in more detail below. Medium leading section 42 and heating unit coupling surface 44 together form a coupling surface 45.

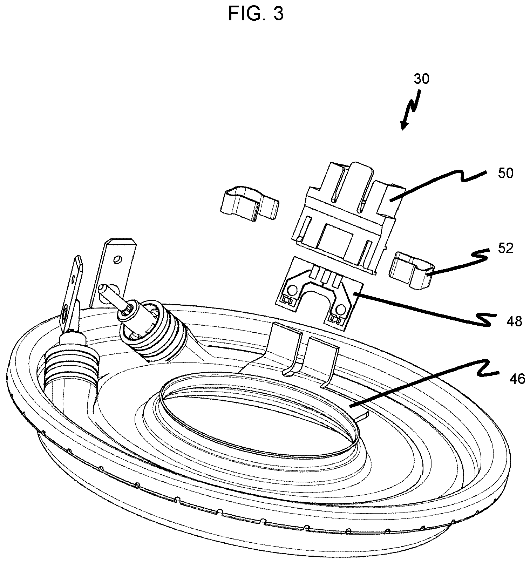

Fig. 3 shows heating system component 18 shown in Fig. 2 with an exploded view of temperature sensor 30. Temperature sensor 30 comprises a heat conducting plate assembly 46, a printed circuit board 48, a housing 50, and, optionally, a biasing element 52, which in the example shown in Fig. 3 comprises two metal springs.

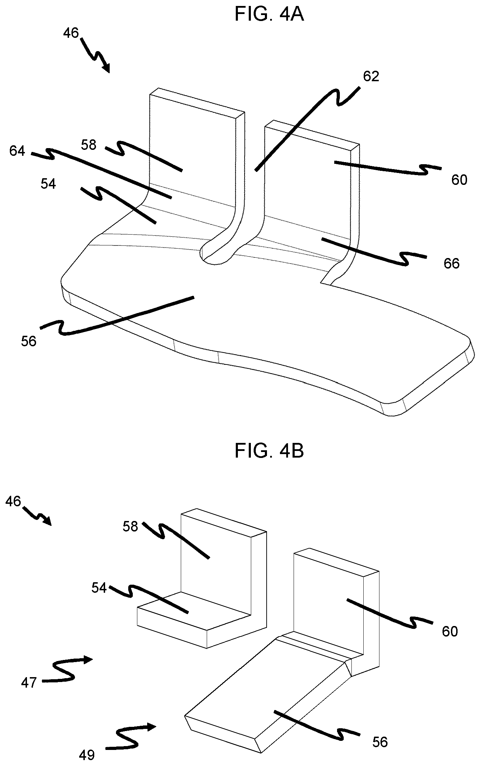

Fig. 4A shows a perspective view of heat conducting plate assembly 46 with a single plate body. Heat conducting plate assembly 46 comprises a first heat capturing plate portion 54, a second heat capturing plate portion 56, a first heat releasing plate portion 58, and a second heat releasing plate portion 60. Heat conducting plate assembly 46 shown in Fig. 4A is integrally formed by punching and bending from a metal sheet having good thermal conductivity. Alternatively, heat conducting plate assembly 46 may be formed from a plurality of plates that are attached to each other. In any of these two cases, the heat conducting plate assembly has a single plate body. Heat conducting plate assembly 46 is thermally coupled to heating unit coupling surface 44 and medium leading section 42 as will be described below.

Fig. 4B shows a perspective view of a heat conducting plate assembly 46 with a first plate body 47 and a second plate body 49. First plate body 47 comprises first heat capturing plate portion 54 and first heat releasing plate portion 58. Second plate body 49 comprises second heat capturing plate portion 56 and second heat releasing plate portion 60. First plate body 47 and second plate body 49 are spatially separated from each other. Therefore, thermal conduction between first and second plate body 47, 49 is reduced and the temperature measurement is more accurate. Heat conducting plate assembly 46 may alternatively comprise more than two plate bodies such as three, four, or more plate bodies.

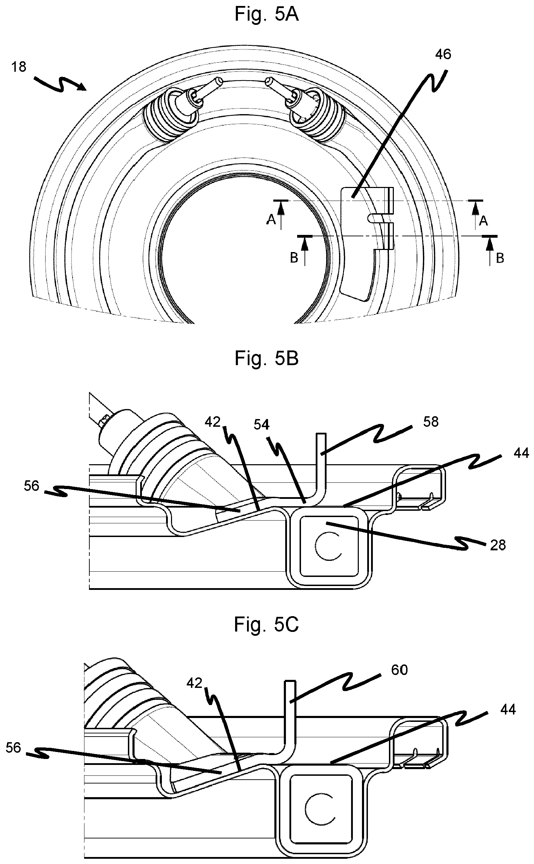

Fig. 5A shows a partial top view of heating system component 18 and heat conducting plate assembly 46.

Fig. 5B shows a cross section through heating system component 18, first heat capturing plate portion 54, second heat capturing plate portion 56, and first heat releasing plate portion 58 along a plane A-A as shown in Fig. 5A. First heat capturing plate portion 54 is attached to and therefore thermally coupled to heating unit coupling surface 44. Second heat capturing plate portion 56 is attached to and therefore thermally coupled to medium leading section 42. In the example seen in Fig. 5B, cross section of the medium leading section 42 is essentially straight. Due to its rotational symmetry, medium leading section 42 therefore has essentially the shape of a cone section. Second heat capturing plate portion 56 has a similar surface shape in order to align with the cone shape of medium leading section 42. Alternatively, second heat capturing plate portion 56 may have a different shape, such as a straight plate, wherein attachment material (such as soldering paste or glue) is filling empty spaces between second heat capturing plate portion 56 and medium leading section 42 in order to ensure a proper thermal coupling.

Fig. 5C shows a cross section through heating system component 18, second heat capturing plate portion 56, and second heat releasing plate portion 60 along a plane B-B as shown in Fig. 5A. As can be seen in Figs. 5B and 5C, second heat capturing plate portion 56 does not touch heating unit coupling surface 44 and is therefore exclusively thermally coupled to medium leading section 42 on the dry side of the carrier unit.

First heat capturing plate portion 54 is thermally coupled to heating unit 28. First heat releasing plate portion 58 is thermally coupled to first heat capturing plate portion 54 and therefore thermally coupled to heating unit 28. Consequently, assuming equilibrium conditions, first heat releasing plate portion 58 has the same (or essentially the same) temperature as heating unit 28.

Second heat capturing plate portion 56 is thermally coupled to medium leading section 42. Second heat releasing plate portion 60 is thermally coupled to second heat capturing plate portion 56 and therefore thermally coupled to medium leading section 42. Consequently, assuming equilibrium conditions, second heat releasing plate portion 60 has the same (or essentially the same) temperature as medium leading section 42.

It is noted that, second heat capturing plate portion 56 is indirectly thermally coupled to heating unit coupling surface 44 via first heat capturing plate portion 54. But due to an asymmetric heat conductivity of heat conducting plate assembly 46 (as will be described further below) the transfer of heat from the heating unit 28 to second heat releasing plate portion 60 is insignificant.

Heat conducting plate assembly 46 comprises a recess 62 (see Fig. 4A) that extends between first heat releasing plate portion 58 and first heat capturing plate portion 54 on one side and second heat releasing plate portion 60 on the other side. Recess 62 forms a thermal isolation between first heat releasing plate portion 58 and second heat releasing plate portion 60, which reduces a heat equalization between both heat releasing plate portions 58, 60. Furthermore, recess 62 also forms a thermal isolation between first heat capturing plate portion 54 and second heat releasing plate portion 60. As a result of this shape of heat conducting plate assembly 46, a thermal conductivity from first heat capturing plate portion 54 to first heat releasing plate portion 58 is larger than to second heat releasing plate portion 60 and a thermal conductivity from second heat capturing plate portion 56 to second heat releasing plate portion 60 is larger than to first heat releasing plate portion 58. Alternatively or additionally to recess 62, heat conducting plate assembly 46 may comprise a tapering or a thermally insulating material (such as glass wool). Heat conducting plate assembly 46 may further comprise a tapering or a thermally insulating material between first heat capturing plate portion 54 and second heat capturing plate portion 56. A heat conducting plate assembly 46 as described above has an asymmetric heat conductivity that causes first heat releasing plate portion 58 to primarily adapt the temperature of first heat capturing plate portion 54 and second heat releasing plate portion 60 to primarily adapt the temperature of second heat capturing plate portion 56.

Heat conducting plate assembly 46 as depicted in Fig. 4B has two separate plate bodies 47, 49, which can be understood as a recess extending entirely through heat conducting plate assembly 46. Heat conducting plate assembly 46 shown in Fig. 4B consequently has an increased thermal isolation between first heat capturing plate portion 54 and first heat releasing plate portion 58 on one side and second heat capturing plate portion 56 and second heat releasing plate portion 60 on the other side and consequently a larger asymmetry in heat conductivity.

First heat capturing plate portion 54 is attached to heating unit coupling surface 44 (as shown in Fig. 5B). Second heat capturing plate portion 56 is attached to medium leading section 42 (as shown in Fig. 5B). The attachment of first and second heat capturing plate portions 54, 56 may be realized by soldering, gluing, laser beam welding, or high temperature joining.

Heat conducting plate assembly 46 comprises a first bent 64 between first heat capturing plate portion 54 and first heat releasing plate portion 58 and a second bent 66 between second heat capturing plate portion 56 and second heat releasing plate portion 60. First and second bents 64, 66 cause first and second heat releasing plate portions 58, 60 to extend away from carrier unit 26. As will be described further below, printed circuit board 48 is oriented at least essentially parallel to first and second heat releasing plate portions 58, 60. Such an orientation improves access for consecutive plugs (e.g., a standard edge connector socket such as a RAST 5 connector) to electrodes on printed circuit board 48. Furthermore, unnecessary exposure of printed circuit board 48 to heat generated by heating unit 28 can be reduced. First and second bent 64, 66 may have an angle between 25° and 155°, preferably between 45° and 135°, and further preferably between 80° and 100°, such as at least essentially 90° (as shown in Figs. 4A and 4B).

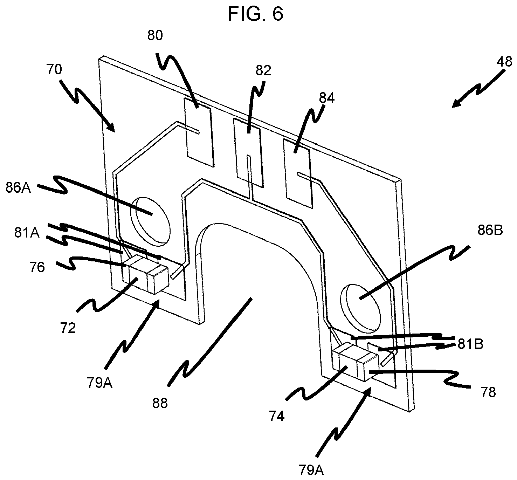

Fig. 6 shows a perspective view of printed circuit board 48. Printed circuit board 48 comprises circuitry 70 with a first sensor area 72 and a second sensor area 74, wherein circuitry 70 is configured to sense a first temperature at first sensor area 72 and a second temperature at second sensor area 74.

Circuitry 70 shown in Fig. 6 comprises a first thermistor 76 and a second thermistor 78, wherein a surface of the thermistor 76 comprises first sensor area 72 and a surface of second thermistor 78 comprises second sensor area 74. Generally, a thermistor has a temperature dependent resistance. Based on a known relationship between a thermistor temperature and a thermistor resistance, a temperature of the thermistor can be determined based on a determined resistance of the thermistor. Consequently, for the circuitry shown in Fig. 6, the first temperature at first sensor area 72 can be determined based on a first resistance determined for first thermistor 76. Likewise, the second temperature at second sensor area 74 can be determined based on a second resistance determined for second thermistor 78. First and second thermistors 76, 78 shown in Fig. 6 are negative temperature coefficient (NTC) thermistors, wherein resistance decreases as temperature rises. Alternatively, first and second thermistors 76, 78 may be positive temperature coefficient (PCT) thermistors, wherein resistance increases as temperature rises. Circuitry 70 is not limited to the use of thermistors. Any other electrical device that can be arranged on printed circuit board 48 configured to provide a temperature sensing area may be used instead.

Printed circuit board 48 may comprise first and second footprints 79A, 79B to which first and second thermistors 76, 78 are attached to (e.g., by soldering). First footprint 79A comprises a first set of two pads 81A and second footprint 79B comprises a second set of two pads 81 B. Each pad of sets of pads 81A, 81B may have a rectangular shape (such as a square shape). For example, each pad may have a rectangular shape with a first side length between 0.21mm and 1.00mm, preferably between 0.50mm and 0.95mm, such as at least essentially 0.90mm, and a second side length between 0.30mm and 2.5mm, preferably between 0.80mm and 1.60mm, such as at least essentially 1.30mm, wherein the first side length extends parallel to an extension of corresponding thermistor 76, 78 and the second side length extends perpendicular to the extension of corresponding thermistor 76, 78. The two pads of each of the first and second sets of pads 81A, 81B may be arranged apart at an edge-to-edge distance between 0.40mm and 2.20mm, preferably between 0.70mm and 2.20mm, such as at least essentially 1.00mm.

Circuitry 70 comprises a first electrode 80, a second electrode 82, and a third electrode 84, wherein first thermistor 76 is electrically connected to first and second electrode 80, 82 and second thermistor 78 is electrically connected to second and third electrode 82, 84. Such a circuitry 70 has low complexity and allows measurements of the first and second resistances with only three electrodes 80-84. Alternatively, circuitry 70 may comprise electrically separate circuits for each thermistor 76, 78 with two electrodes, respectively.

Printed circuit board 48 comprises two openings 86A, 86B and a recessed edge 88. Alternatively, printed circuit board 48 may comprise only one opening or more than two openings. Furthermore, printed circuit board 48 may comprise more than one recessed edge 88, such as in Fig. 6 on the left and right edge of printed circuit board 48. Openings 86A, 86B and recessed edge 88 reduce the mass and therefore the heat capacity of printed circuit board 48. As a result, upon a temperature change, printed circuit board 48 (and the temperature sensor 30) reaches a thermal equilibrium faster, which leads to a more accurate and/or faster temperature measurement. Alternatively, printed circuit board 48 may have a rectangular shape with no openings and no recessed edge.

Printed circuit board 48 has a thickness that is smaller than or equal to 1.6mm. For example, printed circuit board 48 may have a thickness of at least essentially 1.0mm, 0.5mm, or 0.3mm. As a result, printed circuit board 48 has a lower mass and a lower heat capacity as described above.

Printed circuit board 48 shown in Fig. 6 has a single layer. Alternatively, printed circuit board 48 may have two layers, wherein a circuitry is arranged on both sides of printed circuit board 48. In such a case, the printed circuit board may have at least one opening with an electrical connection that electrically connects both layers of printed circuit board 48.

In the case of a printed circuit board 48 with two layers, the circuitry may comprise a third sensor area (not shown) that is thermally coupled to a third heat releasing plate portion (not shown) of the heat conducting plate assembly 46 and the circuitry is configured to sense a third temperature at the third sensor area, wherein first and second sensor areas 72, 74 are arranged on one of the two layers and the third sensor area is arranged on the other one of the two layers. The third heat releasing plate portion may be thermally coupled (e.g., via a third heat capturing plate portion that may be part of a third plate body or of a single plate body) to heating unit 28 or medium leading section 42. The third sensor area may be used for a redundant temperature measurement or for measuring a mean temperature in combination with first or second sensor area 72, 74. The circuitry is not limited to three sensor areas and may alternatively have four, five, six, or more sensor areas.

In either case of the single or two layer printed circuit board, circuit 70 may comprise a processing unit (not shown) configured to receive first temperature data indicative of the first temperature sensed by first sensor area 72 at heating unit 28 and second temperature data indicative of the second temperature sensed by second sensor area 74 at medium leading section 42, wherein the processing unit is configured to determine the first temperature based on the first temperature data and the second temperature based on the second temperature data. The processing unit may have access to the relationship between temperature and resistance for each of first and second thermistors 76, 78. The first and second temperature data may comprise the first and second resistances determined for first and second thermistors 76, 78. The processing unit may further comprise or control a power source that is used for determining the first and second resistances. The processing unit is then able to determine the temperature at first and second sensor areas 72, 74 based on the determined first and second resistances and the relationships between the temperature and resistance for each of first and second thermistors 76, 78.

The processing unit may further be configured to generate a shut off instruction in the case that a safety criterion is fulfilled. The safety criterion may comprise that the first and/or second temperature exceed a threshold temperature. The safety criterion may additionally or alternatively comprise that the first and/or second temperature exceed a threshold for a rate of change of the temperature. The safety criterion may additionally or alternatively comprise that a difference between the first and second temperature exceeds a temperature difference threshold. An excessive temperature or excessive rate of change of the temperature may be indicative of no or insufficient medium flow. The processing unit may be configured to control heating unit 28 directly, wherein the instruction causes heating unit 28 to shut down. Alternatively, the processing unit may be communicatively connected to a separate device that is configured to control heating unit 28, wherein the separate device controls heating unit 28 to shut down upon receipt of the instruction of the processing unit.

Printed circuit board 48 shown in Fig. 6 comprises a glass-reinforced epoxy laminate material of the NEMA grade FR-4, which is flame retardant and therefore suitable for heating applications. Alternatively or additionally, printed circuit board 48 may comprise a flame-retardant composite epoxy material such as CEM III. Printed circuit board 48 may comprise an insulated metal substrate. An insulated metal substrate comprises a metal substrate (e.g., aluminium) and a metal wiring or metal sheets (e.g., copper) that is electrically isolated from the metal substrate by a dielectric. Such an insulated metal substrate has a high resistance to heat, mechanical resilience and thermal conductivity. A high thermal conductivity is beneficial for thermal coupling of first and second heat releasing plate portions 58, 60 to first and second sensor areas 72, 74 without a physical contact between first and second heat releasing plate portions 58, 60 and first and second sensor areas 72, 74. Therefore, first and second heat releasing plate portions 58, 60 and first and second sensor areas 72, 74 can be arranged on opposite sides of printed circuit board 48. However, such an opposite arrangement may also be realized with a glass-reinforced epoxy laminate material of the NEMA grade FR-4 or other materials as described above and is not limited to a printed circuit board comprising an insulated metal substrate.

The epoxy in the glass-reinforced epoxy laminate material of the NEMA grade FR-4 and/or the flame retardant composite epoxy material such as CEM III may have a glass-transition temperature Tg larger than 170 °C. In particular for heating applications that use water as medium 24, operation temperatures at printed circuit board 48 usually do not exceed 100 °C. A glass-transition temperature Tg larger than 170 °C ensures a long lifetime of printed circuit board 48 in such temperatures. The printed circuit board 48 may comprise a ceramic printed circuit board.

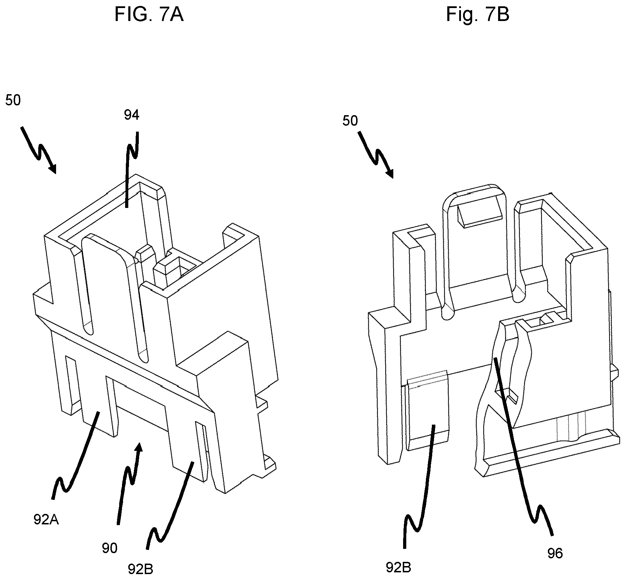

Fig. 7A shows a perspective view of housing 50. Housing 50 has an accommodation opening 90 configured to receive at least a part of printed circuit board 48 and at least a part of heat conducting plate assembly 46. Housing 50 is configured to accommodate at least a part of printed circuit board 48 and at least a part of heat conducting plate assembly 46 in such a way that first sensor area 72 is thermally coupled to first heat releasing plate portion 58 and second sensor area 74 is thermally coupled to second heat releasing plate portion 60. Housing 50 further comprises two (i.e. for each heat releasing plate portions 58, 60) holding elements 92. When heat conducting plate assembly 46 is accommodated inside housing 50, each of heat releasing plate portions 58, 60 can abut from the inside against holding elements 92.

Housing 50 further comprises a socket 94 configured to receive a standard edge connector socket, such as a RAST 5 connector as will be described further below.

Fig. 7B shows a perspective cutaway view of housing 50 shown in Fig. 7A from essentially an opposite viewing angle. Housing 50 further comprises a support plate 96. When printed circuit board 48 is accommodated inside housing 50, printed circuit board 48 can abut from the inside against support plate 96. Housing 50 may comprise a step at accommodation opening 90 or a recess in support plate 96 in order to secure printed circuit 48 inside housing 50.

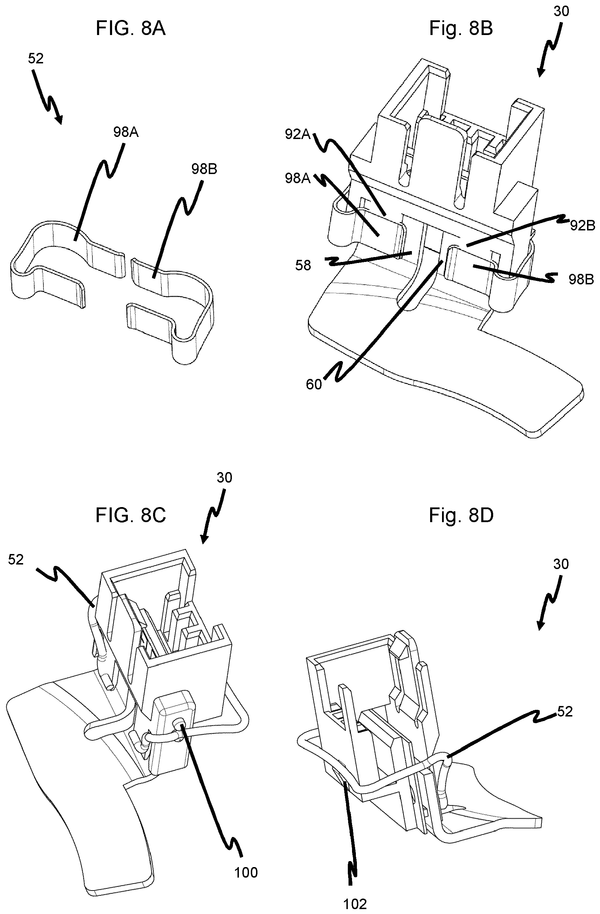

Fig. 8A shows biasing element 52 that is configured to bias first heat releasing plate portion 58 towards first sensor area 72 and second heat releasing plate portion 60 towards second sensor area 74. Biasing element 52 shown in Fig. 8A comprises a first and second metal spring 98A, 98B in form of U-shaped clamps. Alternatively, biasing element 52 may comprise a single metal spring. Biasing element 52 may alternatively or additionally comprise a plastic. The plastic may be a high temperature plastic that is stable at higher operating temperatures such as up to 150° C, or up to 170 °C, preferably up to 190 °C.

Fig. 8B shows temperature sensor 30 with biasing element 52 attached thereto. Holding elements 92A, 92B are respectively arranged between first and second heat releasing plate portion 58, 60 and biasing element 52. Biasing element 52 frictionally engages heat releasing plate portions 58, 60 and holding elements 92A, 92B, which secures housing 50 to heat conducting plate assembly 46.

Fig. 8C shows a perspective view and Fig. 8D shows a cutaway perspective view of temperature sensor 30 with an alternative biasing element 52 in form of a metal strap. As can be seen in Fig. 8C, housing 50 may have at least one leverage point 100 that biasing element 52 is adapted to contact. Housing 50 may further have a hook 102 that is configured to secure biasing element 52.

Further alternatively, heating system component 18 comprises no biasing element 52. Such a heating system component 18 has a lower complexity and is easier to manufacture.

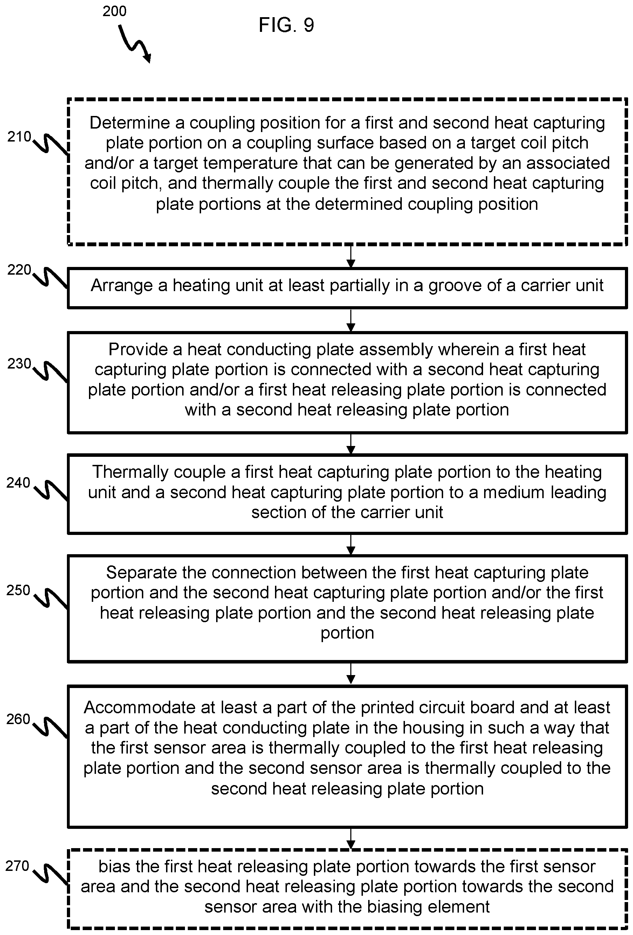

Fig. 9 shows schematically and exemplarily an embodiment of a method 200 for manufacturing a heating system component 18, wherein the heat conducting plate assembly 46 comprises a first plate body 47 and a second plate body 49 such as described above.

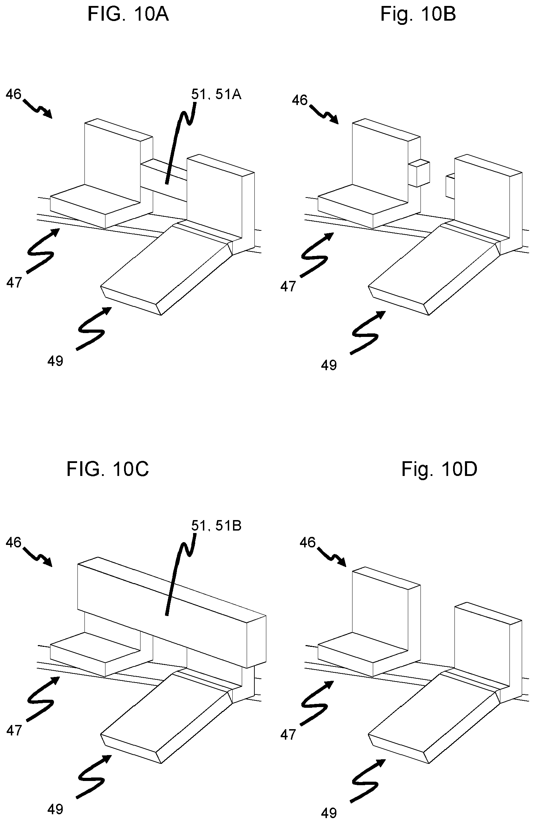

Method 200 comprises in step 220, arranging heating unit 28 at least partially in groove 34 of carrier unit 26. Method 200 also comprises in step 230 providing of heat conducting plate assembly 46 wherein first heat capturing plate portion 54 is connected with second heat capturing plate portion 56 and/or first heat releasing plate portion 58 is connected with second heat releasing plate portion 60 wherein the connection of respective plate portions 54, 56, 58, 60 is done by a connecting element in such a way that first and second plate body 47, 49 are arranged in a separated and fixed spatial relationship to each other. Fig. 10A shows a perspective view of heat conducting plate assembly 46, wherein a connecting element 51 comprises a crosspiece 51A between first plate body 47 and second plate body 49 as shown in Fig. 10A. The crosspiece 51A may be formed integrally with first and second plate body 47, 49, such as by punching and bending and/or welding. The crosspiece 51A can be located anywhere between both plate bodies 47, 49, preferably at the top end of both bodies 47, 49 referred to Fig. 10A. Alternatively, the crosspiece 51A may not be integrally formed. In such a case, crosspiece 51A may be formed by a connecting element 51 in the form of a connecting cap 51B, as shown in Fig. 10C. The connecting cap 51B may be coupled to first and second plate body 47, 49 by different a means of attachment that comprises at least one of a screw, a nail, a magnet, and an adhesive.

Method 200 further comprises in step 240, thermally coupling first heat capturing plate portion 54 to heating unit 28 and second heat capturing plate portion 56 to medium leading section 42 of carrier unit 26. The thermal coupling may be realized by attachment in form of soldering, gluing, laser beam welding, or high temperature joining. Method 200 also comprises in step 250, separating the connection between first heat capturing plate portion 54 and second heat capturing plate portion 56 and/or first heat releasing plate portion 58 and second heat releasing plate portion 60. During the thermal coupling, connecting element 51 ensures that first and second plate body 47, 49 maintain a fixed orientation and position relative to each other. In the case that connecting element 51 comprises crosspiece 51A such as shown in Fig. 10A, separating connecting element 51 may be realized by cutting through crosspiece 51A. The separating may comprise at least one of cutting, sawing, plier cutting, and oxy-fuel cutting. Fig. 10B shows heat conducting plate assembly 46, wherein crosspiece 51A is cut through and consequently first and second plate body 47, 49 are separated. Since the connecting element 51 was coupled to first and second plate body 47, 49 before thermally coupling first and second heat capturing plate portion 54, 56 to heating unit 28 and medium leading section 42, an arrangement of first and second plate body 47, 49 can be maintained that ensures thermal isolation between first and second plate body 47, 49 and ensures an arrangement of first and second heat releasing plate portions 58, 60 that can be thermally coupled to printed circuit board 48. Connecting element 51 may unintentionally create a thermal link between first and second plate body 47, 49 and/or block a coupling of the heat conducting plate assembly 46 to printed circuit board 48. Therefore, connecting element 51 is decoupled from first and second plate body 47, 49 after thermally coupling first and second heat capturing plate portions 54, 56 to heating unit 28 and medium leading section 42.

Fig. 10C shows heat conducting plate assembly 46 with a different example for a connecting element 51 that comprises a connecting cap 51B with openings (not shown) configured to receive first and second plate body 47, 49 in such a way that first and second plate body 47, 49 are arranged in a separated and fixed spatial relationship to each other. To this end, connecting cap 51B may frictionally engage first and second plate body 47, 49. Alternatively or additionally, connecting cap 51B may comprise at least one of an adhesive, a suction cup, and a magnet configured to fix first and second plate body 47, 49 relative to each other.

Fig. 10D shows heat conducting plate assembly 46 depicted in Fig. 10C, wherein the first and second plate body 47, 49 are separated by removing connecting cap 51B.

Method 200 further comprises in step 260, accommodating at least a part of printed circuit board 48 and at least a part of heat conducting plate assembly 46 in housing 50 in such a way that first sensor area 72 is thermally coupled to first heat releasing plate portion 58 and second sensor area 74 is thermally coupled to second heat releasing plate portion 60.

In an optional step 210, heating unit 28 comprises a heating coil and a pitch of the coil varies along an extension of heating coil, wherein carrier unit 26 and heating unit 28 have coupling surface 45 (see Fig. 2) that extends along at least a part of the varying pitch of the heating coil and that is configured to allow thermal coupling to first and second heat capturing portions 54, 56, wherein method 200 comprises determining a coupling position for first and second heat capturing plate portions 54, 56 on coupling surface 45 based on a target coil pitch and/or a target temperature that can be generated by an associated position on the coupling surface 45, and thermally coupling first and second heat capturing plate portions 54, 56 at the determined coupling position.

In a further optional step 270, method 200 comprises biasing first heat releasing plate portion 58 towards first sensor area 72 and second heat releasing plate portion 60 towards second sensor area 74 with biasing element 52.

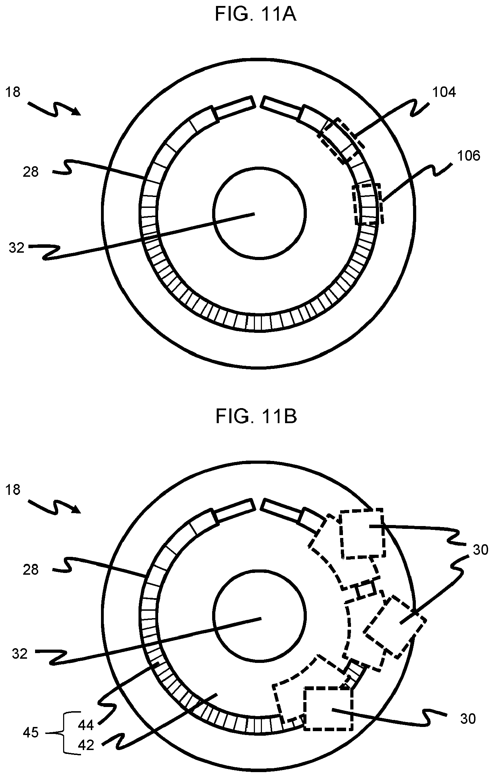

Fig. 11A shows a schematic top view of heating system component 18 with heating unit 28. Heating unit 28 comprises a coil (not shown) with a varying coil pitch, wherein Fig. 11A indicates the coil pitch with a plurality of lines inside heating unit 28. The distance between the lines increases with increasing pitch of the coil. Consequently, the coil pitch is larger at the ends of heating unit 28 than in the middle of heating unit 28. As a consequence, heating unit 28 generates more heat in the middle than at its end. For example, a first coil region 104 shown in Fig. 11A is at a position with a large coil pitch and consequently at a colder position. A second coil region 106 is at a position with a smaller coil pitch and consequently at a warmer position. For heating system component 18, a relationship between the coupling position on coupling surface 45 and the temperature at the coupling position can be determined (e.g., by measurement or simulation).

Fig. 11B shows a schematic top view of heating system component 18 shown in Fig. 11A with temperature sensor 30 arranged at different positions on coupling surface 45. First and second heat capturing plate portions 54, 56 can be arranged at the determined coupling position based on the relationship between the coupling position on coupling surface 45 and the temperature at the coupling position.

The different temperatures for coupling positions as described above are mostly related to the coil pitch. Therefore the different coupling positions described above are arranged along an extension of the heating coil and consequently of heating unit 28. However, the coupling positions are not limited thereto. The temperature of the coupling position may also depend on a distance relative to the heating unit 28. For example, temperature sensor 30 is exposed to higher temperatures when coupled at a coupling position on top of the heating unit 28 compared to a coupling position between heating unit 28 and carrier opening 32 or between heating unit 28 and an edge of carrier unit 26. As a consequence, the temperature for the coupling position can vary along two degrees of freedom, i.e. along heating element 28 and spaced away from heating element 28 (such as, for example, in Fig. 11B temperature sensor 30 depicted at the button, which is arranged offset to the heating element 28). Therefore, a selection for the coupling position and the temperature assigned to the coupling position spans across the coupling surface 45 of the carrier unit 26.

Heating system component 18 may be installed in applications with different operation temperatures. For example, washing machines often heat water up to a temperature of 40 °C, dish washer to 60 °C, and coffee machines up at 100 °C. Temperature sensor 30 may have a preferred temperature range for operation. Using the relationship between the coupling position on coupling surface 45 and the temperature at the coupling position, temperature sensor 30 can be arranged at a position that is within or at least closer to the preferred temperature range.

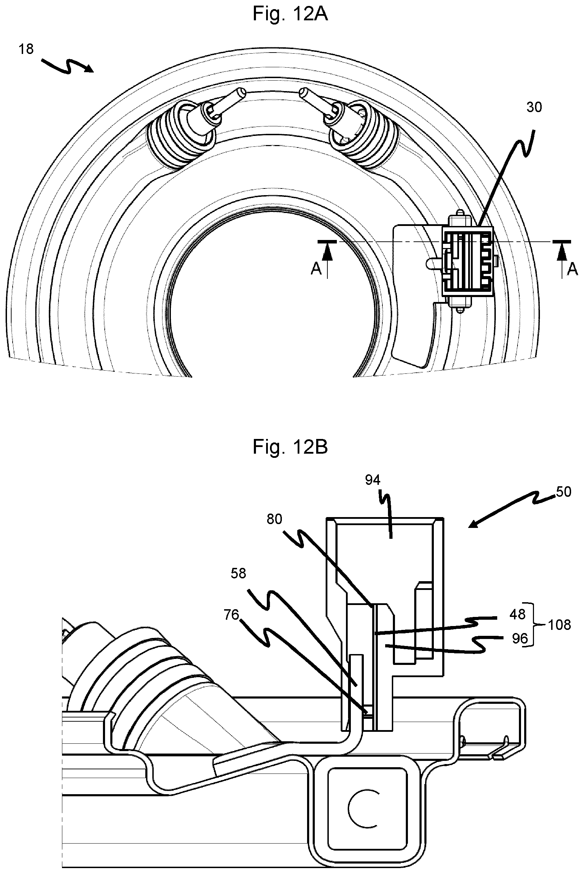

Fig. 12A shows a top view of manufactured heating system component 18 (such as shown in Fig. 2).

Fig. 12B shows a cross section through heating system component 18 and temperature sensor 30 along a plane A-A as shown in Fig. 12A.

As can be seen in Fig. 12B, printed circuit board 48 is entirely accommodated in housing 50 and abuts against (or is attached to) support plate 96. Alternatively, only a part of printed circuit board 48 is accommodated inside housing 50. That may be the case when printed circuit board 48 has a layer on each side and a part of a layer that is not supposed to abut against support plate 96 instead extends out of housing 50. First thermistor 76 faces away from support plate 96 and first sensor area 72 of first thermistor 76 abuts against first heat releasing plate portion 58, therefore creating a thermal coupling. A surface of first heat releasing plate portion 58 that faces away from first thermistor 76 abuts (or is attached to) holding element 92A. Optionally, biasing element 52 as described above may be provided in order to bias first heat releasing plate portion 58 towards first sensor area 72.

Housing 50 comprises socket 94 configured to receive a standard edge connector socket, such as a RAST 2.5 connector or a as a RAST 5 connector (not shown). Printed circuit board 48 and support plate 96 form a plate stack 108 wherein plate stack 108 is dimensioned such that it can be received by such a standard edge connector socket. The standard edge connector socket (not shown) can engage plate stack 108 from both sides creating a form fit connection. The electrical connector may have electrical contacts that are configured to be electrically connected to electrodes 80-84. A separate device connected via the standard edge connector socket to temperature sensor 30 can therefor receive the first temperature data indicative of the first temperature sensed by first sensor area 72 and the second temperature data indicative of the second temperature sensed by second sensor area 74. Alternatively or additionally, a processing unit as described above may be provided for determining the first and second temperature. The processing unit may be connected to electrodes (e.g., electrodes 80, 82, 84) that allow the processing unit to communicate with the separate device, e.g., for the purpose of communicating the determined first and second temperature.

Support plate 96 provides mechanical stability to plate stack 108, reducing the risk of mechanically damaging printed circuit board 48. Furthermore, printed circuit board 48 may be too thin to be engaged by the standard edge connector socket, especially in the case that a thinner printed circuit board 48 (e.g., a thickness of 0.3mm) is provided such as described above. In such a case, support plate 96 provides sufficient wall thickness for plate stack 108 to be thick enough in order to be engaged by the standard edge connector socket. For example, the standard edge connector socket may be a RAST 2.5 connector or a RAST 5 connector that is configured to engage a standard printed circuit board with a thickness of 1.6mm. For example, a printed circuit board 48 with a thickness of 0.3mm and a support plate 96 with a thickness of 1.3mm may then provided, which results in a plate stack 108 with a total thickness of 1.6mm which is compatible with the RAST 2.5 connector or the RAST 5 connector.

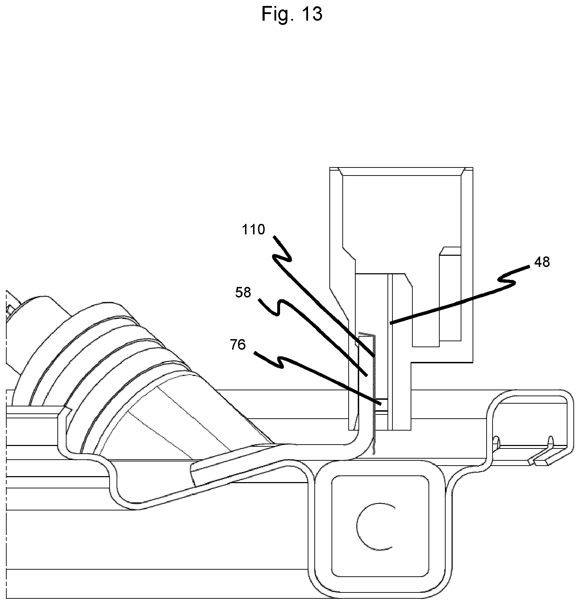

Fig. 13 shows a second embodiment of heating system component 18 shown in Fig. 12B, which essentially differs in a foil 110 arranged between first heat releasing plate portion 58 and first sensor area 72 as well as between second heat releasing plate portion 60 and second sensor area 74. Foil 110 comprises a material with electrically isolating and thermally conducting properties, such as a polyimide foil (e.g., Kapton MT). Consequently, foil 110 prevents an electrical shortcut in circuitry 70 (such as first and second thermistors 76, 78 or wiring connected thereto), while keeping a thermal barrier caused by foil 110 at a minimum.

The foil 110 shown in Fig. 13 is attached to first and second heat releasing plate portions 58, 60. Alternatively, foil 110 may be attached to printed circuit board 48 or only to first and second thermistors 76, 78.

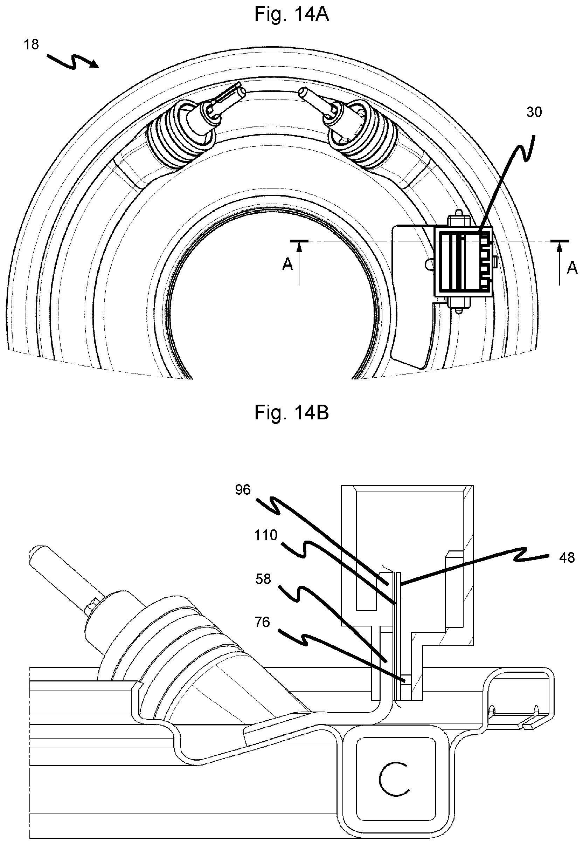

Fig. 14A shows a partial top view of a third embodiment of heating system component 18, wherein first and second sensor areas 72, 74 face away from first and second heat releasing plate portions 58, 60.

Fig. 14B shows a partial cross section through heating system component 18 along a plane A-A as shown in Fig. 14A. The main difference between the third embodiment depicted in Fig. 14B and the first embodiment shown in Fig. 12B or the second embodiment shown in Fig. 13 is that first and second sensor areas 72, 74 are arranged on a surface of printed circuit board 48 that is facing away from first and second heat releasing plate portions 58, 60. Consequently, printed circuit board 48 is arranged between first and second heat releasing plate portions 58, 60 and first and second thermistors 76, 78 (as well as first and second sensor areas 72, 74 that are part thereof). Therefore, first and second sensor areas 72, 74 are thermally coupled with first and second heat releasing plate portions 58, 60 via the printed circuit board 48. While any of the printed circuit boards described herein are capable of realizing said thermal coupling, a printed circuit board comprising an insulated metal substrate and/or glass-reinforced epoxy laminate material of the NEMA grade FR-4 have a comparably high thermal conductivity, which results in less time required to reach thermal equilibrium. The temperature measurements therefore are faster and/or more accurate.

Foil 110 may in such a case be arranged between first and second heat releasing plate portions 58, 60 and printed circuit board 48 as shown in Fig. 14B. Foil 110 reduces the risk of a shortcut on the printed circuit board 48. Foil 110 may be attached to at least one of printed circuit board 48, first and second heat releasing plate portions 58, 60, and support plate 96. Alternatively, no foil 110 may be provided.

## Claims

1. A heating system component (18), comprising:
a carrier unit (26) having a dry side (38), a wet side (40), a groove (34) provided on the dry side (38), and a medium leading section (42) at least partially opposite a medium flow area on the wet side (40);
a heating unit (28) at least partially received in the groove (34);
a heat conducting plate assembly (46) that comprises a first heat capturing plate portion (54) that is thermally coupled to the heating unit (28), a second heat capturing plate portion (56) that is thermally coupled to the medium leading section (42) of the carrier unit (26), a first heat releasing plate portion (58), and a second heat releasing plate portion (60);
at least one printed circuit board (48) comprising circuitry (70) with a first sensor area (72) and a second sensor area (74), wherein the circuitry (70) is configured to sense a first temperature at the first sensor area (72) and a second temperature at the second sensor area (74);
a housing (50) accommodating at least a part of the printed circuit board (48) and at least a part of the heat conducting plate assembly (46) in such a way that the first sensor area (72) is thermally coupled to the first heat releasing plate portion (58) and the second sensor area (74) is thermally coupled to the second heat releasing plate portion (60).

2. The heating system component (18) according to claim 1,
wherein the second heat capturing plate portion (56) is exclusively thermally coupled to the medium leading section (42) on the dry side (38) of the carrier unit (26).

3. The heating system component (18) according to preceding claim 1 or 2, wherein the heat conducting plate assembly (46) has a shape and/or is made of a material, in particular a composite material, such that a thermal conductivity from the first heat capturing plate portion (54) to the first heat releasing plate portion (58) is larger than to the second heat releasing plate portion (60) and a thermal conductivity from the second heat capturing plate portion (56) to the second heat releasing plate portion (60) is larger than to the first heat releasing plate portion (58).

4. The heating system component (18) according to any of the preceding claims 1 to 3,
wherein the heat conducting plate assembly (46) comprises a recess (62) that extends at least partially between the first heat releasing plate portion (58) and the first heat capturing plate portion (54) on one side and the second heat re-leasing plate portion (60) on the other side.

5. The heating system component (18) according to any of the preceding claims,
wherein the heat conducting plate assembly (46) comprises a first bent (64) between the first heat capturing plate portion (54) and the first heat releasing plate portion (58) and a second bent (66) between the second heat capturing plate portion (56) and the second heat releasing plate portion (60).

6. The heating system component (18) according to any of the preceding claims, further comprising:
at least one biasing element (52) configured to bias the first heat releasing plate portion (58) towards the first sensor area (72) and the second heat releasing plate portion (60) towards the second sensor area (74).

7. The heating system component (18) according to any of the preceding claims,
wherein the housing (50) comprises at least one holding element (92) preferably arranged at least partially between a biasing element (52) and the first and/or second heat releasing plate portions (58, 60).

8. The heating system component (18) according to any of the preceding claims,
wherein the printed circuit board (48) comprises a third sensor area that is thermally coupled to a third heat releasing plate portion of the heat conducting plate assembly (46) and the printed circuit board (48) is configured to sense a third temperature at the third sensor area, wherein the printed circuit board (48) comprises two layers and the first and second sensor areas (72, 74) are arranged on one of the two layers and the third sensor area is arranged on the other one of the two layers.

9. The heating system component (18) according to any of the preceding claims,
wherein the printed circuit board (48) comprises at least one of an opening (86A, 86B) and a recessed edge (88).

10. The heating system component (18) according to any of the preceding claims, further comprising a foil (110) arranged between the first heat releasing plate portion (58) and the first sensor area (72) as well as between the second heat releasing plate portion (60) and the second sensor area (74), wherein the foil (110) comprises a material with electrically isolating and thermally conducting properties, such as a polyimide foil (e.g., Kapton MT).

11. A heated conveyer pump (10) for conveying a fluid medium (24), comprising:
a pump housing (12) accommodating an impeller (14),
a drive unit (16) for driving the impeller (14); and
the heating system component (18) according to any of the claims 1 to 10.

12. A method (200) for manufacturing a heating system component (18), wherein the heating system component (18) comprises a carrier unit (26) having a dry side (38), a wet side (40), a groove (34) provided on the dry side (38), and a medium leading section (42) at least partially opposite a medium flow area on the wet side (40), a heating unit (28), a heat conducting plate (46) that comprises a first heat capturing plate portion (54), a second heat capturing plate portion (56), a first heat releasing plate portion (58), and a second heat releasing plate portion (60), at least one printed circuit board (48) comprising circuitry (70) with a first sensor area (72) and a second sensor area (74), wherein the circuitry (70) is configured to sense a first temperature at the first sensor area (72) and a second temperature at the second sensor area (74), and a housing (50), the method (200) comprising the steps of
arranging (220) the heating unit (28) at least partially in the groove (34) of the carrier unit (26);
providing (230) of the heat conducting plate assembly (46) wherein the first heat capturing plate portion (54) is connected with the second heat capturing plate portion (56) and/or the first heat releasing plate portion (58) is connected with the second heat releasing plate portion (60);
thermally coupling (240) the first heat capturing plate portion (54) to the heating unit (28) and the second heat capturing plate portion (56) to the medium leading section (42) of the carrier unit (26);
separating (250) the connection between the first heat capturing plate portion (54) and the second heat capturing plate portion (56) and/or the first heat releasing plate portion (58) and the second heat releasing plate portion (60); and
accommodating (260) at least a part of the printed circuit board (48) and at least a part of the heat conducting plate assembly (46) in the housing (50) in such a way that the first sensor area (72) is thermally coupled to the first heat releasing plate portion (58) and the second sensor area (74) is thermally coupled to the second heat releasing plate portion (60).

13. The method (200) according to claim 12, wherein
the heating unit (28) comprises a heating coil and a pitch of the coil varies along an extension of the heating coil, wherein the carrier unit (26) and the heating unit (28) have a coupling surface (45) that extends along at least a part of the varying pitch of the heating coil and that is configured to allow thermal coupling to the first and second heat capturing plate portions (54, 56), wherein the method (200) comprises
determining (210) a coupling position for the first and second heat capturing plate portions (54, 56) on the coupling surface (45) based on a target coil pitch and/or a target temperature that can be generated by an associated position on the coupling surface (45); and
thermally coupling the first and second heat capturing plate portions (54, 56) at the determined coupling position.

14. A printed circuit board (48) for sensing a first and a second temperature as defined in claims 1 to 10.

15. A housing (50) for accommodating at least a part of a printed circuit board (48) and at least a part of a heat conducting plate assembly (46) as defined in claims 1 to 10.
